**Europäisches Patentamt**

**European Patent Office**

**Office européen des brevets**

(11) Veröffentlichungsnummer: **0 114 175**
**B1**

(12) **EUROPÄISCHE PATENTSCHRIFT**

(45) Veröffentlichungstag der Patentschrift:
**14.09.88**

(21) Anmeldenummer: **83104870.7**

(22) Anmeldetag: **17.05.83**

(51) Int. Cl.⁴: **H 05 K 7/02**

(54) **Baugruppenträger für einseitig bestückte Flachbaugruppen in Planaranordnung.**

(30) Priorität: **21.12.82 DE 3247300**

(43) Veröffentlichungstag der Anmeldung:
**01.08.84 Patentblatt 84/31**

(45) Bekanntmachung des Hinweises auf die Patenterteilung:
**14.09.88 Patentblatt 88/37**

(84) Benannte Vertragsstaaten:
**AT BE CH DE FR GB IT LI NL**

(56) Entgegenhaltungen:
**FR - A - 2 135 328**
**FR - A - 2 293 122**
**US - A - 4 336 673**

**PROCEEDINGS OF THE S.I.D., Band 21, Nr. 2, 1980,**
**Seiten 143-155, Los Angeles, US; K.T. BURNETTE et al.:**
**"Multi-mode matrix (MMM) modular flight display**
**development"**

(73) Patentinhaber: **Siemens Aktiengesellschaft Berlin und München, Wittelsbacherplatz 2, D-8000 München 2 (DE)**

(72) Erfinder: **Wessely, Herrmann, Dipl.-Ing.,**
**Paul-Hösch-Strasse 1, D-8000 München 60 (DE)**
Erfinder: **Hatheier, Reinhard, Josef-Sammer-Strasse 19,**
**D-8022 Grünwald (DE)**

## Beschreibung

Die Erfindung betrifft einen Baugruppenträger für mehrere einseitig bestückte Flachbaugruppen in Planaranordnung.

Der Einsatz von schnellen, integrierten Schaltkreisen in Form von Mikrobausteinen beim Aufbau von grossen elektronischen Systemen, beispielsweise von Datenverarbeitungsanlagen, vermindert den Platzbedarf und erhöht wegen der geringen Leitungslänge die Schaltgeschwindigkeit. Die Mikrobausteine können in Flachbaugruppen mit hoher Packungsdichte verschaltet sein, wobei die dabei notwendigen zahlreichen Aussenanschlüsse auf engstem Raum auf der Unterseite verteilt sind und eine planare Anordnung auf einer als Baugruppenträger dienenden Verdrahtungsplatte bedingen. Um eine hohe Leiterdichte zu erreichen bestehen diese vorwiegend aus einer Leiterplatte mit miteinander verklebten, elektrisch isolierenden Schichten, auf welchen in parallelen Ebenen geätzte Leitungsmuster zur Signalleitung und Leitungsflächen zur Potentialeinspeisung verlaufen.

Die Potentialverteilung auf den Potentialebenen soll auch beim Betreiben einer grossen Anzahl von Flachbaugruppen möglichst gleichmässig sein, was jedoch durch unterschiedliche Spannungsabfälle an einzelnen Flachbaugruppen und durch eine ungleichmässige Verteilung der Potentialabgriffe in starkem Mass beeinträchtigt ist. Der Erfindung lag daher die Aufgabe zugrunde, einen Baugruppenträger der oben genannten Art anzugeben, welcher eine Potentialeinspeisung in nächster Nähe zu den kritischen Spannungsabfällen ermöglicht.

Diese Aufgabe wird dadurch gelöst, dass auf der Bestückungsseite einer Verdrahtungsplatte ein steifer Gitterrahmen befestigt ist, dessen Gitterzwischenräume als formschlüssige Einsteckkammern für jeweils eine Flachbaugruppe ausgebildet sind, und dass der Gitterrahmen mit mindestens einem zum Betrieb der Flachbaugruppe erforderlichen Spannungspotential beaufschlagt und mit Potentialflächen der Verdrahtungsplatte an Orten mit einem hohen Spannungsabfall galvanisch verbunden ist.

Auf diese Weise wird eine weitgehend gleichmässige Potentialverteilung auf den Potentialflächen erreicht. Ausserdem bewirkt der Gitterrahmen eine mechanische Versteifung der Verdrahtungsplatte, welche Zug- oder Biegekräfte aufnimmt und dadurch Beschädigungen der empfindlichen Leiterbahnstruktur verhindert. Die Einsteckkammern haben den Vorteil, dass beim Stecken oder Ziehen einer Flachbaugruppe eine Zentrierung bzw. Führung erfolgt, welche eine Beschädigung der Kontaktfedern und Kontaktstifte verhindert. Ansonsten besteht die Gefahr, dass durch tangential angreifende Kräfte Kontaktstifte verbogen oder abgebrochen werden. Der relativ grosse Querschnitt des Gitters gewährleistet eine niederohmige Verbindung zu allen Flachbaugruppen. Da die Gitterstruktur die Leiterplatte relativ engmaschig überzieht, kann der Ort der Durchkontaktierung zur Potentialfläche ohne grosse Einschränkungen den Erfordernissen angepasst werden.

Wenn der Gitterrahmen aus Gitterelementen zusammengesetzt ist, die jeweils aus einer Längsschiene mit mehreren, die Querstreben des Gitters bildenden, zumindest auf einer Seite senkrecht abstehenden Schienenfortsätzen bestehen, so ist es möglich, aus vorgefertigten Gitterelementen unterschiedlich grosse Funktionseinheiten, bestehend aus Flachbaugruppen und Leiterplatte, zusammenzusetzen.

Es ist vorteilhaft, die Gitterelemente durch eine elektrische Isolation an den freien Stirnflächen der Schienenfortsätze von den benachbarten Gitterelemente zu trennen, die Gitterelemente jeweils mit unterschiedlichen Betriebspotentialen zu beaufschlagen und mit verschiedenen Potentialflächen zu verbinden. Auf diese Weise werden Spannungsabfälle in mehreren, mit unterschiedlichen Potentialen beaufschlagten Potentialflächen ausgeglichen.

Um einen Spannungsabfall innerhalb eines Gitterelementes zu verringern, sind in einer Weiterbildung der Erfindung die Längsschienen an beiden Enden mit Kontaktierungsvorrichtungen zum Anlegen der Betriebspotentiale versehen.

Im folgenden wird die Erfindung anhand eines bevorzugten Ausführungsbeispiels weiter beschrieben.

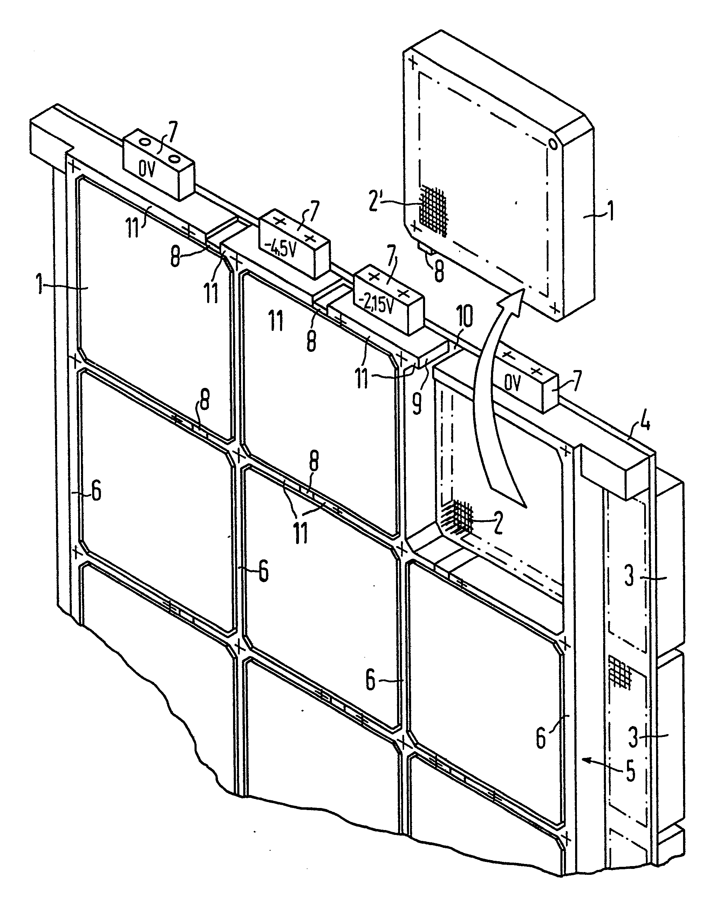

Die Figur zeigt einen Baugruppenträger mit Flachbaugruppen in Planaranordnung. Der Baugruppenträger besteht aus einer Funktionseinheit aus einer Verdrahtungsplatte 4, aus einem darauf befestigten Gitterrahmen 5 und aus mehreren Flachbaugruppen 1.

Die Flachbaugruppen 1 sind in ihrer äusseren Form durch ein Steckverbinderteil bestimmt, welches die vier schmalen Ränder der Flachbaugruppe 1 einfasst, und auf dessen einer Flachseite eine Vielzahl von Kontaktelementen 2' in rasterartig verteilte Kammern eingesetzt ist. Auf der zweiten Flachseite ist eine metallische Kühlplatte in das Steckverbinderteil eingebettet, unter welcher, in der Figur nicht sichtbar, integrierte Mikrobausteine verschaltet sind.

Die Kontaktelemente 2' bestehen aus Stiften oder Kontaktfedern, deren Gegenstücke 2 innerhalb eines Gitterzwischenraums auf der Leiterplatte 4 befestigt sind. Zur Veranschaulichung ist eine der Flachbaugruppen 1 in Pfeilrichtung aus dem zugehörigen Gitterzwischenraum nach oben herausgeklappt, und gibt somit die Sicht frei auf die Kontaktelemente 2' und ihre Gegenstücke 2. Die übrigen Flachbaugruppen 1 sind in planarer Anordnung in die Gitterzwischenräume gesteckt. Die Leiterplatte 4 besteht aus mehreren, miteinander verklebten isolierenden Schichten, auf welchen geätzte Leitermuster zur Signalleitung und Leiterflächen zur Potentialeinspeisung verlaufen. Von den Signalleitungen und den Potentialflächen führen Durchkontaktierungen zu den Kontaktelementen 2'. Zum externen Anschluss der Funktionseinheit ist die Leiterplatte 4 auch mit Steckerleisten 3 versehen.

Der Gitterrahmen 5 ist auf der die Flachbaugruppen 1 tragenden Bestückungsseite mit der Leiterplatte 4 verschraubt. Er ist aus Gitterelementen zusammengesetzt, die jeweils aus einer Längsschiene 6 und mehreren, die Querstreben des Gitters bildenden Schienenfortsätzen 11 bestehen, wobei die Gitterzwischenräume formschlüssige Einsteckkammern für jeweils eine Flachbaugruppe 1 bilden. Die Längsschienen 6 verlaufen parallel zueinander und reichen von einem Ende der Leiterplatte 4 zum anderen. Die beiden, die äusseren Ränder des Gitters bildenden Schienen weisen nur an ihrer Innenseite die senkrecht abstehenden Schienenfortsätze 11 auf, während die übrigen Schienen 6 auf beiden Seiten mit Schienenfortsätzen 11 versehen sind. An den Stirnseiten 9 der Gitterfortsätze 11 sind zum benachbarten Gitterelement Trennfugen 10 ausgespart, die durch einen Isolationskörper 8 ausgefüllt sind.

An beiden Enden der Gitterelemente sind an den Aussenseiten der Schienenfortsätze 11 jeweils Kontaktierungsvorrichtungen zum Anlegen der Betriebspotentiale befestigt. Sie bestehen aus Schraubverbindungen, mit welchen die zu einer Stromversorgung führenden Leiter angeklemmt sind (nicht dargestellt). Jedes Gitterelement ist mit einem Potential beaufschlagt, das sich vom Potential des benachbarten Gitterelementes unterscheidet. An den beiden äusseren Gitterelementen liegt beispielsweise das Erdpotential, während an die beiden mittleren Gitterelemente beispielsweise −4,5 Volt oder +2,15 Volt angelegt sind. Beim Einsetzen der Flachbaugruppen in den Gitterrahmen werden diese bezüglich der Kontaktelemente 2' und deren Gegenstücke 2 zentriert und erhalten beim Einstecken eine Führung, die eine Beschädigung der Kontaktierungselemente 2' und ihrer Gegenstücke 2 verhindert. Mittels Durchkontaktierungen zu den entsprechenden Schichten der Leiterplatte 4 werden die Mikrobausteine der Flachbaugruppe 1 mit den Leitungsmustern und den Potentialflächen der Leiterplatte 4 verbunden. Die Potentialeinspeisung erfolgt über den Gitterrahmen 5, welcher über Durchkontaktierungen mit den Potentialebenen der Leiterplatte 4 verbunden ist. Die Durchkontaktierungen sind an den Stellen ausgeführt, die nahe an grösseren Spannungsabfällen auf den Potentialflächen liegen. Sie sind in der Figur durch « + » gekennzeichnet.

## Patentansprüche

1. Baugruppenträger für mehrere einseitig bestückte Flachbaugruppen in Planaranordnung, dadurch gekennzeichnet, dass auf der Bestückungsseite einer Verdrahtungsplatte (4) ein steifer, elektrisch leitender Gitterrahmen (5) befestigt ist, dessen Gitterzwischenräume als formschlüssige Einsteckkammern für jeweils eine Flachbaugruppe (1) ausgebildet sind, und dass der Gitterrahmen (5) mit mindestens einem zum Betrieb der Flachbaugruppen erforderlichen Potential beaufschlagt und mit Potentialflächen der Verdrahtungsplatte (4) an Orten mit einem hohen Spannungsabfall galvanisch verbunden ist.

2. Baugruppenträger nach Anspruch 1, dadurch gekennzeichnet, dass der Gitterrahmen (5) aus Gitterelementen zusammengesetzt ist, die jeweils aus einer Längsschiene (6) mit mehreren, die Querstreben des Gitters bildenden, zumindest auf einer Seite senkrecht abstehenden Schienenfortsätzen (11) bestehen.

3. Baugruppenträger nach einem der Ansprüche 1 oder 2, dadurch gekennzeichnet, dass die Gitterelemente (5) durch eine elektrische Isolation (8) an den freien Stirnflächen (9) der Schienenfortsätze (11) von den benachbarten Gitterelementen getrennt sind, und dass die Gitterelemente jeweils mit unterschiedlichen Betriebspotentialen beaufschlagt sind.

4. Baugruppenträger nach einem der Ansprüche 1 bis 3, dadurch gekennzeichnet, dass die Gitterelemente an beiden Enden mit Kontaktierungsvorrichtungen (7) zum Anlegen der Betriebspotentiale versehen sind.

## Claims

1. An assembly carrier for a plurality of flat assemblies, loaded on one side, in a planar arrangement, characterised in that on the assembly side of a circuit board (4), there is attached a rigid, electrically conductive grid frame (5) whose grid spaces form form-fitting plug-in chambers each for one flat assembly (1), and that the grid frame (5) is supplied with at least one potential required for the operation of the flat assemblies and is electrically connected to potential surfaces of the circuit board (4) at locations of a high voltage drop.

2. An assembly carrier as claimed in Claim 1, characterised in that the grid frame (5) is composed of grid elements which each consist of a longitudinal bar (6) with a plurality of bar projections (11) which project at right angles at least on one side and which form the cross-members of the grid.

3. An assembly carrier as claimed in one of the Claims 1 or 2, characterised in that the grid elements (5) are separated from the adjacent grid elements by an electrical insulation (8) at the free end faces (9) of the bar projections (11), and that the grid elements are each supplied with different operating potentials.

4. An assembly carrier as claimed in one of the Claims 1 to 3, characterised in that the grid elements are provided at both ends with contacting devices (7) for the connection of the operating potentials.

## Revendications

1. Porte-modules pour plusieurs modules plats munis de composants sur une seule face et agencés selon une disposition planar, caractérisé par le fait que sur la face de montage des composants d'une plaquette de câblage (4) se trouve fixé un cadre en forme de grille (5) rigide et électriquement conducteur, dont les cavités sont réalisées sous la forme de chambres d'enfichage de forme adaptée pour des modules plats respectifs (1), et que le cadre en forme de grille (5) est chargé par au moins un potentiel nécessaire pour faire fonctionner le module plat et est relié galvariquement à des surfaces d'application de potentiels de la plaquette de câblage (4) en des emplacements au niveau desquels apparaît une chute de tension élevée.

2. Porte-modules suivant la revendication 1, caractérisé par le fait que le cadre en forme de grille (5) est formé par la réunion d'éléments de grille, qui sont constitués chacun par un rail longitudinal (6) comportant plusieurs appendices saillants (11) qui forment les barres transversales de la grille et font saillie perpendiculairement au moins d'un côté.

3. Porte-modules suivant l'une des revendications 1 ou 2, caractérisé par le fait que les éléments de grille sont séparés des éléments de grille voisins par une isolation électrique (8) au niveau des surfaces frontales libres (9) des appendices saillants (11) des rails, et que les éléments de grille sont chargés respectivement par des potentiels de service différents.

4. Porte-modules suivant l'une des revendications 1 à 3, caractérisé par le fait que les éléments de grille comportent, au niveau de leurs deux extrémités, des dispositifs de contact (7) servant à appliquer les potentiels de service.